# FASCICULE DE BREVET EUROPEEN

(11) **EP 2 831 974 B1**
(45) Date de publication et mention de la délivrance du brevet: **29.04.2020**
(21) Numéro de dépôt: 13715374.8
(22) Date de dépôt: 26.03.2013
(51) Int. Cl.: H02J 7/00, G01R 31/36

(54) **SYSTEME DE GESTION DE LA CHARGE D'UNE BATTERIE D'ACCUMULATEURS**
BATTERIELADEVERWALTUNGSSYSTEM
CHARGE MANAGEMENT OF A BATTERY STACK

(30) Priorité: 30.03.2012 FR 1200971
(43) Date de publication de la demande: 04.02.2015
(73) Titulaire: Renault S.A.S., 92100 Boulogne-Billancourt (FR)
(72) Inventeur: PEUCHANT, Thomas, F-75014 Paris (FR); LE VOURCH, Yves, F-78150 Le Chesnay (FR); SAINT-MARCOUX, Antoine, F-91120 Palaiseau (FR)
(86) Numéro de dépôt international: PCT/FR2013/050652
(87) Numéro de publication internationale: WO 2013/144499

(56) Documents cités:
- EP-A1- 1 107 344
- US-A1- 2007 145 944
- US-B1- 6 377 024

## Description

### DOMAINE TECHNIQUE AUQUEL SE RAPPORTE L'INVENTION

La présente invention concerne de manière générale la charge d'une batterie d'accumulateurs.

Elle concerne plus particulièrement un système de gestion de la charge d'au moins une cellule d'une batterie d'accumulateurs selon la revendication 1.

### ARRIERE-PLAN TECHNOLOGIQUE

Les véhicules automobiles à propulsion électrique sont généralement équipés d'une batterie d'accumulateurs dédiée, communément appelée batterie de traction, et d'un moteur électrique alimenté en courant par cette batterie de traction.

Cette batterie de traction est formée d'une pluralité de cellules d'accumulateurs de tailles réduites, dont le nombre est calculé de telle sorte que le moteur électrique puisse développer un couple et une puissance suffisants pour propulser le véhicule pendant une durée prédéterminée.

Ces cellules de batterie d'accumulateurs sont généralement empilées de manière particulièrement compacte, et sont logées dans un boîtier de stockage fermé hermétiquement.

Lors de la charge des cellules, l'apparition d'une surtension est alors susceptible d'entraîner une inflammation de la batterie d'accumulateurs, voire une explosion du boîtier de stockage.

Cette surtension s'avère particulièrement dangereuse lorsque le véhicule automobile est en charge pendant la nuit à l'intérieur d'un garage accolé à une habitation.

Il est alors connu de prévoir un système de gestion tel que défini en introduction, qui puisse détecter une telle surtension et stopper alors la charge de la batterie d'accumulateurs. Les publications US2007145944 , US6377024 et EP1107344 divulguent de tels systèmes.

La norme internationale ISO-26262 permet de quantifier la dangerosité d'un événement survenant sur un véhicule automobile, via un coefficient ASIL. Ce coefficient permet ainsi de déterminer les risques de non-arrêt de la charge de la batterie d'accumulateurs à domicile en cas de surtension d'une cellule.

Actuellement, eu égard aux risques de défaillance des composants utilisés pour la fabrication des systèmes de gestion, les systèmes de gestion du type précité obtiennent un coefficient ASIL C sur l'événement considéré.

La demanderesse souhaite toutefois réduire encore les risques d'inflammation des cellules d'accumulateurs, et obtenir ainsi un coefficient ASIL D plus exigent. Malheureusement, quand bien même elle utiliserait des composants plus fiables, l'architecture du système de gestion précité ne permettrait pas d'obtenir un tel coefficient ASIL D.

### OBJET DE L'INVENTION

Afin d'obtenir un tel coefficient ASIL D, on propose alors un système de gestion tel que défini dans l'introduction, dans lequel il est prévu :
- un second moyen de comparaison de la tension aux bornes de ladite cellule avec ladite tension seuil, qui est distinct dudit premier moyen de comparaison, et
- un second moyen de commande, qui est distinct dudit premier moyen de commande et qui est adapté à commander un second actionneur pour interrompre la charge de la batterie d'accumulateurs lorsque ledit second moyen de comparaison détecte que la tension aux bornes de ladite cellule est supérieure à ladite tension seuil. Selon l'invention, le premier actionneur est formé par un chargeur qui est connecté à ladite batterie d'accumulateurs pour recharger lesdites cellules ;

Ainsi, grâce à l'invention, on utilise en parallèle deux chemins distincts pour mesurer, comparer et interrompre la charge de la batterie d'accumulateurs. Il est alors très peu probable que les composants utilisés dans les deux chemins tombent simultanément en panne. On réduit ainsi d'autant les risques de non-détection d'une surtension et d'inflammation de la batterie d'accumulateurs.

D'autres caractéristiques avantageuses et non limitatives du système de gestion conforme à l'invention sont les suivantes :
- ledit second actionneur comporte au moins un relais situé entre l'une des bornes de la batterie d'accumulateurs et l'une des bornes d'un chargeur ;
- lesdits premier et second moyens de commande appartiennent respectivement à un premier microprocesseur et un second microprocesseur de types différents ; on notera ici que l'un et/ou l'autre des microprocesseurs pourront être formés par des composants plus autonomes tels que des microcontrôleurs ;
- lesdits premier et second moyens de comparaison comportent respectivement une première interface analogique-numérique et une seconde interface analogique-numérique de types différents ;
- ladite première interface analogique-numérique numérise la tension aux bornes de ladite cellule et la transmet à un comparateur qui compare la tension numérisée avec la tension seuil ;
- ledit comparateur appartient au premier microprocesseur ;
- ladite seconde interface analogique-numérique est adaptée à comparer analogiquement la tension aux bornes de ladite cellule avec la tension seuil et à transmettre un signal numérisé fonction du résultat de ladite comparaison ;
- ledit premier actionneur est distinct dudit second actionneur ;
- ledit second actionneur comporte deux relais respectivement situés entre les deux bornes du chargeur et les deux bornes de la batterie d'accumulateurs.

### DESCRIPTION DETAILLEE D'UN EXEMPLE DE REALISATION

La description qui va suivre en regard du dessin annexé, donné à titre d'exemple non limitatif, fera bien comprendre en quoi consiste l'invention et comment elle peut être réalisée.

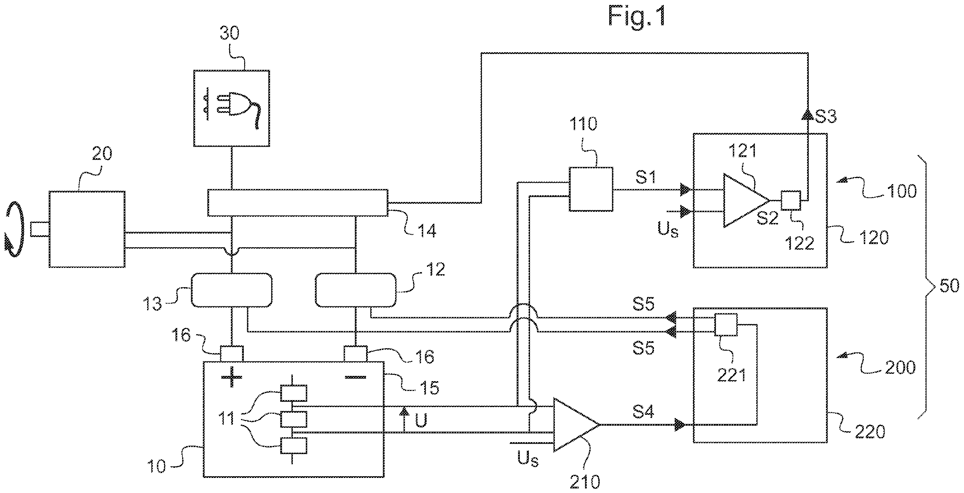

Sur ce dessin, la figure 1 est une vue schématique d'un groupe motopropulseur et d'un système de gestion de charge d'une cellule d'accumulateurs de ce groupe motopropulseur.

Sur la figure 1, on a ainsi représenté un groupe motopropulseur 1.

Ce groupe motopropulseur 1 comporte un moteur électrique 20 conçu pour propulser un véhicule automobile, et une batterie de traction 10 dédiée à l'alimentation en courant de ce moteur électrique 20.

Cette batterie de traction 10 comporte un boîtier de stockage 15 duquel émergent deux bornes de phase et de neutre 16, et une pluralité de cellules d'accumulateurs 11 de tailles réduites, qui sont logées à l'intérieur du boîtier de stockage 15 et qui sont branchées en série entre les bornes de phase et de neutre 16 de la batterie de traction 10.

Ici, ces cellules d'accumulateurs 11 sont du type Lithium-ion. Une fois chargées, chacune de ces cellules d'accumulateurs 11 présente une tension à ses bornes comprise entre 3,5 et 4,5 V.

Pour la clarté de la figure 1, on a seulement représenté trois cellules d'accumulateurs 11. La batterie de traction 10 en comportera bien entendu un nombre supérieur.

Le nombre de cellules d'accumulateurs 11 sera alors calculé de telle sorte que le moteur électrique 20 puisse développer un couple et une puissance suffisants pour propulser le véhicule pendant une durée prédéterminée.

Typiquement, on utilisera une centaine de cellules d'accumulateurs 11 de manière que la tension aux bornes de phase et de neutre 16 de la batterie de traction 10 soit de l'ordre de 400 V.

Le groupe motopropulseur 1 comporte par ailleurs deux relais 12, 13 qui sont respectivement connectés aux deux bornes de phase et de neutre 16 de la batterie de traction 10, entre la batterie de traction 10 et le moteur électrique 20.

Ces deux relais 12, 13 sont pilotables entre un état fermé (cas général) et un état ouvert (en cas de problème).

Le groupe motopropulseur 1 comporte également un chargeur 14 comprenant deux entrées d'alimentation en courant électrique et deux bornes de sortie.

Ces deux bornes de sortie sont respectivement connectées aux deux bornes de phase et de neutre 16 de la batterie de traction 10, via les deux relais 12, 13.

On comprend donc que l'ouverture des relais 12, 13 permet d'arrêter la charge de la batterie de traction 10 en cas de problème.

L'une des entrées du chargeur 14 est connectée à une fiche électrique 30 susceptible d'être branchée dans une prise de courant.

Lors de la charge de la batterie de traction 10, il peut apparaître une surtension aux bornes de l'une des cellules d'accumulateurs 11. Une telle surtension est alors susceptible d'entraîner une inflammation de la batterie de traction 10.

Pour éviter une telle inflammation, il est alors prévu un système de gestion 50 qui permet d'interrompre la charge de la batterie de traction 10 dès lors qu'une surtension est détectée aux bornes de l'une des cellules d'accumulateurs 11.

Pour la clarté de la figure 1 et de cet exposé, on a seulement représenté et décrit une partie de ce système de gestion 50, qui s'applique à une seule des cellules d'accumulateurs 11. Bien entendu, ce système de gestion 50 s'appliquera de la même manière aux autres cellules d'accumulateurs 11.

Selon l'invention, pour éviter toute défaillance dans la détection d'une surtension, le système de gestion 50 est doublé, en ce sens qu'il comporte deux chemins 100, 200 distincts pour comparer la tension U aux bornes de la cellule d'accumulateurs 11 considérée avec une tension seuil Us et pour commander l'interruption de la charge en cas de surtension.

Les chemins de détection des surtensions ainsi que les actionneurs utilisent des technologies différentes afin d'éviter des pannes systématiques.

Les chemins sont totalement indépendants afin d'éviter qu'une panne non détectée puisse simultanément affecter les 2 chemins.

Ici, la tension seuil Us est égale à 4,2 V. Une surtension est donc détectée dès lors que la tension U aux bornes de la cellule d'accumulateurs 11 considérée dépasse les 4,2 V.

Le premier chemin 100 comporte ainsi :
- des moyens 110, 121 de mesure de la tension U aux bornes de la cellule d'accumulateurs 11 considérée et de comparaison de la tension mesurée U avec la tension seuil Us, et
- un moyen de commande 122 adapté à commander un premier actionneur pour interrompre la charge de la batterie de traction 10 en cas de surtension détectée par les moyens 110, 121.

Ce premier chemin 100 comporte plus précisément deux composants électroniques, à savoir une interface analogique-numérique 110 et un microcontrôleur 120.

L'interface analogique-numérique 110 est adaptée à numériser la tension U mesurée aux bornes de la cellule d'accumulateurs 11 considérée. Cette interface analogique-numérique 110 est ici formée par un capteur MAX17830 fabriqué par la société MAXIM. Elle mesure ainsi en entrée le potentiel à chacune des bornes de la cellule d'accumulateurs 11 considérée et transmet en sortie, à intervalles réguliers (ici toutes les 10 ms), un signal S1 qui comprend la valeur numérisée de la tension U.

Le microcontrôleur 120 présente alors deux fonctions. Il comporte tout d'abord une fonction de comparateur 121 pour comparer la tension U transmise par l'interface analogique-numérique 110 avec la tension seuil Us et pour transmettre un signal S2 d'alerte si une surtension est détectée pendant une durée prédéterminée (par exemple 2 ms). Il comporte également une fonction de commande 122 pour générer, en cas de surtension, un signal S3 de commande du premier actionneur. Le microcontrôleur 120 ici utilisé comporte la référence STM32F105RCT6 et est fabriqué par la société ST MICROELECTRONICS.

On notera que ce premier chemin 100 du système de gestion 50 n'est pas dédié à la surveillance des surtensions, mais que ses composants sont également utilisés à d'autres fins, notamment pour déterminer la capacité de la batterie d'accumulateurs.

Le second chemin 200 comporte quant à lui :
- des moyens de mesure et de comparaison 210 de la tension U aux bornes de la cellule d'accumulateurs 11 avec la tension seuil Us, et
- un moyen de commande 221 adapté à commander un second actionneur pour interrompre la charge de la batterie de traction 10 en cas de surtension détectée par les moyens de mesure et de comparaison 210.

Ce second chemin 200 comporte plus précisément deux composants électroniques, à savoir une interface analogique-numérique 210 et un microcontrôleur 220.

L'interface analogique-numérique 210 est adaptée à comparer analogiquement la tension U mesurée aux bornes de la cellule d'accumulateurs 11 avec la tension seuil Us. Cette interface analogique-numérique 210 est ici formée par un capteur bq77PL660Q1 fabriqué par la société TEXAS INSTRUMENTS. Elle mesure ainsi en entrée le potentiel à chacune des bornes de la cellule d'accumulateurs 11 considérée et transmet en sortie, à intervalle régulier (ici toutes les 10 ms), un signal S4 d'alerte en cas de surtension.

Le microcontrôleur 220 présente quant à lui une fonction de commande 221 pour générer, en cas de surtension pendant une durée prédéterminée (ici 2 ms), un signal S5 de commande du second actionneur. Le microcontrôleur 220 ici utilisé comporte la référence MC9S12HZ256J3CAL et est fabriqué par la société INFINEON.

On notera que ce second chemin 200 du système de gestion 50 est dédié à la surveillance des surtensions, et que ses composants ne sont donc pas utilisés à d'autres fins.

Les signaux de commande S3, S5 émis par les microcontrôleurs 120, 220 permettant alors d'interrompre la charge de la batterie de traction 10 en cas de surtension aux bornes de la cellule d'accumulateurs 11.

Ces signaux de commande S3, S5 sont à cet effet transmis auxdits premier et second actionneurs.

On pourrait alors prévoir que ces actionneurs soient confondus et formés par exemple par le chargeur, qui serait alors piloté par les deux microcontrôleurs pour arrêter la charge de la batterie de traction.

Toutefois, ici, pour réduire encore le risque de défaillance dans la chaîne de détection des surtensions et d'arrêt de la charge de la batterie de traction 10, les deux actionneurs sont distincts l'un de l'autre. De cette manière, si l'un des actionneurs est défaillant, la charge de la batterie de traction 10 pourra être arrêtée par l'autre actionneur.

Tel que représenté sur la figure 1, le premier actionneur, commandé par le premier chemin 100 du système de gestion 50, est formé par le chargeur 14.

Le second actionneur, commandé par le second chemin 200 du système de gestion 50, est quant à lui formé par au moins l'un des deux relais 12, 13. Il est ici formé des deux relais 12, 13.

Lorsque la batterie d'accumulateurs 10 est en charge sur une prise de courant, le système de gestion 50 fonctionne alors de la manière suivante.

Sur le premier chemin 100, l'interface analogique-numérique 110 numérise à intervalles réguliers (ici toutes les 10 ms) la tension U mesurée aux bornes de la cellule d'accumulateurs 11 et transmet alors le signal S1 au microcontrôleur 120.

Le comparateur 121 du microcontrôleur 120 compare alors, à chaque réception du signal S1, la tension U mesurée avec la tension seuil Us.

Tant que cette tension U mesurée reste inférieure à la tension seuil Us, aucun signal n'est délivré par le comparateur 121.

En revanche, si une surtension est détectée par le comparateur 121, ce dernier émet le signal S2 d'alerte pour que le microcontrôleur 120 transmette le signal S3 de commande de l'arrêt du chargeur 14.

Sur le second chemin 200, l'interface analogique-numérique 210 compare en continu la tension U mesurée aux bornes de la cellule d'accumulateurs 11 avec la tension seuil Us.

Tant que cette tension U mesurée reste inférieure à la tension seuil Us, aucun signal n'est délivré par l'interface analogique-numérique 210.

En revanche, si une surtension est détectée par l'interface analogique-numérique 210, cette dernière transmet à intervalles réguliers (ici toutes les 10 ms) le signal S4 d'alerte au microcontrôleur 220. Lorsque ce signal S4 est reçu quatre fois d'affilée (en 2 ms), le microcontrôleur 220 émet le signal S5 de commande de l'ouverture des relais 12, 13.

Ainsi, la surtension ne se prolonge pas sur une durée suffisante pour provoquer l'inflammation de la cellule d'accumulateurs 11.

En cas de défaillance de l'un ou l'autre des composants de l'un des chemins 100, 200 du système de gestion 50, l'autre chemin du système de gestion permettra alors d'interrompre à lui seul la charge de la batterie de traction 10.

La probabilité d'une défaillance simultanée du chemin 100 associé à son chargeur 14 et du chemin 200 associé à ses relais 12 et 13 est alors très réduite.

Le chargeur 14 présente usuellement un coefficient ASIL B selon la norme internationale ISO-26262, ce qui implique :
- que son risque de défaillance non détectée est inférieur à 10⁻³ FIT (unité mesurant le nombre de défaillances d'un composant par milliard d'heures de fonctionnement), et
- que, sur l'ensemble des composants, la proportion de fautes sans conséquence sur le but recherché (SPFM) est supérieure à 90%.

Les relais 13 et 14 présentent usuellement des coefficients ASIL B selon la norme internationale ISO-26262, ce qui implique :
- que leur risque de défaillance non détectée est inférieur à 10⁻³ FIT, et
- que, sur l'ensemble des composants, la proportion de fautes sans conséquence sur le but recherché (SPFM) est supérieure à 90%

En ayant choisi des composants pour le chemin 100 dont la somme des risques de défaillance est inférieure à 9.10⁻³ FIT, on obtient pour le chemin 100 associé à son chargeur 14 un risque de défaillance inférieur à 10⁻² FIT.

De même, en ayant choisi des composants pour le chemin 200 dont la somme des risques de défaillance est inférieure à 9.10⁻³ FIT, on obtient pour le chemin 200 associé à ses relais 12, 13 un risque de défaillance non détectée inférieur à 10⁻² FIT.

Le risque de défaillances simultanées non détectées à la fois sur le chemin 100 et son chargeur 14 et sur le chemin 200 et ses relais 12, 13 est inférieur à 10⁻⁴ FIT.

Grâce à l'indépendance des deux branches, le risque de défaillance non détectée du système global, composé du chemin 100 associé à son chargeur 14 et du chemin 200 associé à ses relais 12, 13, est alors inférieur à 10⁻⁴ FIT.

Les composants du chemin 100 ont par ailleurs été choisis de telle manière que, sur l'ensemble du chemin 100, la proportion de fautes sans conséquence sur le but recherché (SPFM) est supérieure à 90%.

De même, les composants du chemin 200 ont été choisis de telle manière que, sur l'ensemble du chemin 200, la proportion de fautes sans conséquence sur le but recherché (SPFM) est supérieure à 90%.

Grâce à l'indépendance de ses deux branches, le système composé du chemin 100 associé à son chargeur 14 et du chemin 200 associé à ses relais 12, 13 possède alors les caractéristiques suivantes :
- la proportion de fautes de composants sans conséquence sur le but recherché (SPFM) est supérieure à 99%, et que
- la proportion de fautes de composants qui, seules ou couplées à une autre faute d'un des composants, est sans conséquence sur le but recherché (LFM) est supérieure à 90%.

Selon la norme internationale ISO-26262, le système de gestion 50 présente alors un coefficient ASIL D, ce qui illustre la fiabilité de celui-ci.

La présente invention n'est nullement limitée au mode de réalisation décrit et représenté, mais l'homme du métier saura y apporter toute variante conforme à son esprit.

On pourrait notamment prévoir que le premier chemin commande l'ouverture des relais, tandis que le second chemin commande l'arrêt du chargeur.

On pourrait par ailleurs prévoir que le comparateur (121) du premier chemin ne soit pas intégré au microcontrôleur, mais qu'il forme un composant autonome situé entre l'interface analogique-numérique et le microcontrôleur.

## Revendications

1. Système de gestion (50) de la charge d'au moins une cellule (11) d'une batterie d'accumulateurs (10), comportant :
- un premier moyen de comparaison (110, 121) de la tension (U) aux bornes de ladite cellule (11) avec une tension seuil (Us), et
- un premier moyen de commande (122) adapté à commander un premier actionneur (14) pour interrompre la charge de la batterie d'accumulateurs (10) lorsque ledit premier moyen de comparaison (110, 121) détecte que la tension (U) aux bornes de ladite cellule (11) est supérieure à ladite tension seuil (Us),
- un second moyen de comparaison (210) de la tension (U) aux bornes de ladite cellule (11) avec ladite tension seuil (Us), qui est distinct dudit premier moyen de comparaison (110, 121), et
- un second moyen de commande (221), qui est distinct dudit premier moyen de commande (122) et qui est adapté à commander un second actionneur (12, 13) pour interrompre la charge de la batterie d'accumulateurs (10) lorsque ledit second moyen de comparaison (210) détecte que la tension (U) aux bornes de ladite cellule (11) est supérieure à ladite tension seuil (Us),
le système étant **caractérisé en ce que** ledit premier actionneur est formé par un chargeur (14) qui est connecté à ladite batterie d'accumulateurs pour recharger lesdites cellules, et **en ce que** ledit second actionneur est formé par au moins deux relais (12, 13) respectivement situés entre les deux bornes du chargeur (14) et les deux bornes de la batterie d'accumulateurs (10).

2. Système de gestion (50) selon la revendication précédente, dans lequel lesdits premier et second moyens de commande (122, 221) appartiennent respectivement à un premier microprocesseur (120) et un second microprocesseur (220) d'architectures différentes.

3. Système de gestion (50) selon l'une des revendications précédentes, dans lequel lesdits premier et second moyens de comparaison comportent respectivement une première interface analogique-numérique (110) et une seconde interface analogique-numérique (210) d'architectures différentes.

4. Système de gestion (50) selon la revendication précédente, dans lequel ladite première interface analogique-numérique (110) numérise la tension (U) aux bornes de ladite cellule (11) et la transmet à un comparateur (122) qui compare la tension (U) numérisée avec la tension seuil (Us).

5. Système de gestion (50) selon les revendications 2 à 4, dans lequel ledit comparateur (122) appartient au premier microprocesseur (120).

6. Système de gestion (50) selon l'une des revendications 3 à 5, dans lequel ladite seconde interface analogique-numérique (210) est adaptée à comparer analogiquement la tension (U) aux bornes de ladite cellule (11) avec la tension seuil (Us) et à transmettre un signal numérisé fonction du résultat de ladite comparaison.

7. Système de gestion (50) selon l'une des revendications précédentes, dans lequel ledit premier actionneur (14) est distinct dudit second actionneur (12, 13).

## Patentansprüche

1. Verwaltungssystem (50) zum Verwalten der Ladung mindestens einer Zelle (11) einer Akkumulatorenbatterie (10), umfassend:
- eine erste Vergleichseinrichtung (110, 121) zum Vergleichen der Spannung (U) an den Klemmen der Zelle (11) mit einer Schwellenspannung (Us) und
- eine erste Steuereinrichtung (122), die geeignet ist, einen ersten Aktor (14) zu steuern, um das Laden der Akkumulatorenbatterie (10) zu unterbrechen, wenn die erste Vergleichseinrichtung (110, 121) feststellt, dass die Spannung (U) an den Klemmen der Zelle (11) über der Schwellenspannung (Us) liegt,
- eine zweite Vergleichseinrichtung (210) zum Vergleichen der Spannung (U) an den Klemmen der Zelle (11) mit der Schwellenspannung (Us), die von der ersten Vergleichseinrichtung (110, 121) verschieden ist, und
- eine zweite Steuereinrichtung (221), die von der ersten Steuereinrichtung (122) verschieden ist und die geeignet ist, einen zweiten Aktor (12, 13) zu steuern, um das Laden der Akkumulatorenbatterie (10) zu unterbrechen, wenn die zweite Vergleichseinrichtung (210) feststellt, dass die Spannung (U) an den Klemmen der Zelle (11) über der Schwellenspannung (Us) liegt, wobei das System **dadurch gekennzeichnet ist, dass** der erste Aktor durch eine Ladevorrichtung (14) gebildet wird, die an die Akkumulatorenbatterie angeschlossen wird, um die Zellen wiederaufzuladen, und dass der zweite Aktor durch mindestens zwei Relais (12, 13) gebildet wird, die zwischen den beiden Klemmen der Ladevorrichtung (14) bzw. den beiden Klemmen der Akkumulatorenbatterie (10) gelegen sind.

2. Verwaltungssystem (50) nach dem vorhergehenden Anspruch, bei dem die ersten und zweiten Steuereinrichtungen (122, 221) zu einem ersten Mikroprozessor (120) bzw. einem zweiten Mikroprozessor (220) mit unterschiedlichen Architekturen gehören.

3. Verwaltungssystem (50) nach einem der vorhergehenden Ansprüche, bei dem die ersten und zweiten Vergleichseinrichtungen eine erste Analog-Digital-Schnittstelle (110) bzw. eine zweite Analog-Digital-Schnittstelle (210) mit unterschiedlichen Architekturen umfassen.

4. Verwaltungssystem (50) nach dem vorhergehenden Anspruch, bei dem die erste Analog-Digital-Schnittstelle (110) die Spannung (U) an den Klemmen der Zelle (11) digitalisiert und sie an einen Komparator (122) überträgt, der die digitalisierte Spannung (U) mit der Schwellenspannung (Us) vergleicht.

5. Verwaltungssystem (50) nach den Ansprüchen 2 bis 4, bei dem der Komparator (122) zum ersten Mikroprozessor (120) gehört.

6. Verwaltungssystem (50) nach einem der Ansprüche 3 bis 5, bei dem die zweite Analog-Digital-Schnittstelle (210) geeignet ist, die Spannung (U) an den Klemmen der Zelle (11) analog mit der Schwellenspannung (Us) zu vergleichen und ein digitalisiertes Signal zu übertragen, das vom Ergebnis des Vergleichs abhängig ist.

7. Verwaltungssystem (50) nach einem der vorhergehenden Ansprüche, bei dem der erste Aktor (14) verschieden von dem zweiten Aktor (12, 13) ist.

## Claims

1. System (50) for managing the charging of at least one cell (11) of a storage battery (10), including:
- a first means (110, 121) for comparing the voltage (U) at the terminals of said cell (11) with a threshold voltage (Us), and
- a first control means (122) for controlling a first actuator (14) in order to interrupt the charging of the storage battery (10) when said first comparing means (110, 121) detects that the voltage (U) at the terminals of said cell (11) is greater than said threshold voltage (Us),
- a second means (210) for comparing the voltage (U) at the terminals of said cell (11) with said threshold voltage (Us), which means is separate from said first comparing means (110, 121), and
- a second control means (221), which is separate from said first control means (122) and which is suitable for controlling a second actuator (12, 13) in order to interrupt the charging of the storage battery (10) when said second comparing means (210) detects that the voltage (U) at the terminals of said cell (11) is greater than said threshold voltage (Us),
the system being **characterized in that** said first actuator is formed by a charger (14) that is connected to said storage battery in order to recharge said cells, and **in that** said second actuator is formed by at least two relays (12, 13) located between the two terminals of the charger (14) and the two terminals of the storage battery (10), respectively.

2. Management system (50) according to the preceding claim, in which said first and second control means (122, 221) are part of a first microprocessor (120) and a second microprocessor (220) having different architectures, respectively.

3. Management system (50) according to either of the preceding claims, in which said first and second comparing means include a first analog-digital interface (110) and a second analog-digital interface (210) having different architectures, respectively.

4. Management system (50) according to the preceding claim, in which said first analog-digital interface (110) digitizes the voltage (U) at the terminals of said cell (11) and transmits it to a comparator (122) which compares the digitized voltage (U) with the threshold voltage (Us).

5. Management system (50) according to Claims 2 to 4, in which said comparator (122) is part of the first microprocessor (120).

6. Management system (50) according to one of Claims 3 to 5, in which said second analog-digital interface (210) is suitable for carrying out an analog comparison of the voltage (U) at the terminals of said cell (11) and the threshold voltage (Us) and for transmitting a digitized signal dependent upon the result of said comparison.

7. Management system (50) according to one of the preceding claims, in which said first actuator (14) is separate from said second actuator (12, 13).
